# EUROPEAN PATENT APPLICATION

(11) **EP 2 869 331 A1**
(43) Date of publication of application: **06.05.2015**
(21) Application number: 14189000.4
(22) Date of filing: 15.10.2014
(51) Int. Cl.: H01L 21/02

(54) **Episubstrates for selective area growth of group iii-v material and a method for fabricating a group iii-v material on a silicon substrate**

(30) Priority: 29.10.2013 EP 13190704
(71) Applicant: IMEC VZW, 3001 Leuven (BE)
(72) Inventor: Motsnyi, Vasyl, 3001 Leuven (BE); Dutta, Barundeb, 3001 Leuven (BE); Rosmeulen, Maarten, 3001 Leuven (BE)
(74) Representative: Clerix, André

(57) **Abstract**

The embodiments of the present invention disclose a silicon substrate with a group III-V material and a method for fabricating a group III-V material on a silicon substrate. The method involves providing a silicon substrate (101). A first layer (104) formed atop the silicon substrate (101), is subsequently patterned to expose the underlying silicon substrate (101). A group III-V material layer is formed over the patterned first layer (104) and also on the exposed silicon substrate (101). The group III-V material layer (103) is subjected to chemical mechanical polishing (CMP) to expose the first layer (103) resulting in the formation of a plurality of areas (106) suitable for growing a device layer on the silicon substrate (101).

## Description

### TECHNICAL FIELD

The present invention generally relates the silicon substrates and particularly relates the silicon substrates for growing a group III-V material on selective areas. The present invention more particularly relates to episubstrates with the selective area growth of group III-V material for use in lighting and power electronics applications.

### BACKGROUND OF THE INVENTION

Silicon substrates are well known for their properties such as low cost, large wafer size, relatively higher thermal conductivity and higher electrical conductivity. The ability of the silicon substrates to be integrated with diversified electronic circuits renders them suitable for utilization in domains such as lighting and power electronics applications. Further, the aforementioned advantageous properties associated with the silicon substrates also render them suitable for utilization in epitaxy.

Further the silicon substrates are utilized for an epitaxial growth of nitride layers such as gallium nitride layer, aluminum gallium nitride layer and indium nitride layer. However, a growth of continuous nitride layers on a silicon substrate leads to the generation of crystal defects due to the difference between the lattice constant and thermal expansion coefficients of the silicon substrate and the nitride layers respectively.

The difference in the thermal expansion coefficient of the silicon substrate and nitride layers results in the generation of a tensile stress during the formation of the nitride layer, which in turn pulls and drags the lattice structure of the nitride layer, thereby forming cracks in the nitride layers. The cracks formed in the nitride layer are considered as a crystal defect which significantly reduces the performance and yield of the semiconductor device. Further, the formation and presence of cracks leads to a formation of deep centers in the semiconductor band gap and also causes a breakage of the substrate and a malfunctioning of equipment.

Hence there is a need for fabricating the epitaxial structures free of crystal defects on the silicon substrate. There is also a need for fabricating the silicon substrates with a selective area growth of group III-V material layers thereby significantly reducing the formation of cracks in the nitride layers, such as group III-V nitride layers. Further there is a need for a method of fabricating the episubstrates thereby providing a way for effective stress management during the fabrication of a group III-V material layer on the silicon substrate. Still further, there is a need for a method of fabricating the episubstrates with a selective area growth of group III-V material layer to annihilate the dislocations between the adjacent semiconductor device layers and to facilitate a formation of a semiconductor layer with improved crystal quality.

The abovementioned shortcomings, disadvantages and problems are addressed herein and which will be understood by reading and studying the following specification.

### OBJECTS OF THE EMBODIMENTS

The primary object of the embodiments of the present invention is to provide a method for fabricating silicon substrates with a selective area growth of Group III-V material layer and free of crystal defects.

Another object of the embodiments of the present invention is to provide a method of fabricating silicon substrates with a selective area growth of Group III-V material layer to significantly reduce a formation of cracks in the Group III-V material layers such as group III-V nitride layers.

Yet another object of the embodiments of the present invention is to provide a method of fabricating silicon substrates with a selective area growth of Group III-V material layer to provide an effective stress management during the process of fabrication of a group III-V nitride layer on the silicon substrate.

Yet another object of the embodiments of the present invention is to provide a method of fabricating silicon substrates with a selective area growth of Group III-V material layer to annihilate the dislocations between the adjacent semiconductor device layers and to create a semiconductor layer with improved crystal quality.

Yet another object of the embodiments of the present invention is to provide a method of fabricating silicon substrates with a selective area growth of Group III-V material layer to facilitate self aligned individual device layer isolation.

Yet another object of the embodiments of the present invention is to provide a method of fabricating silicon substrates with a selective area growth of Group III-V material layer to provide a natural surface texturing by facilitating growth of semiconductor device layer on planarized silicon substrate.

Yet another object of the embodiments of the present invention is to provide a method of fabricating silicon substrates with a selective area growth of Group III-V material layer using chemical mechanical polishing techniques.

Yet another object of the embodiments of the present invention is to provide a method of fabricating silicon substrates with a selective area growth of Group III-V material layer, in which a first layer is formed at first.

These and other objects and advantages of the present invention will become readily apparent from the following detailed description taken in conjunction with the accompanying drawings.

### SUMMARY OF THE INVENTION

The various embodiments of the present invention provide a silicon substrate with a selective area growth of group III-V material layers and a method of fabricating the same. According to an embodiment of the present invention, a method of fabricating a group III-V material-on-silicon substrate is provided. According to the method, a silicon substrate is provided. A first layer is formed over the silicon substrate. The first layer is patterned to selectively expose the silicon substrate. A group III-V material layer is formed over the patterned first layer and on the exposed areas of the silicon substrate. The group III-V material layer is subjected to chemical mechanical polishing to expose the first layer thereby forming a plurality of areas suitable for growing a device layer on the silicon substrate.

According to an embodiment of the present invention, the first layer is a layer of a dielectric material. Preferably this dielectric material is silicon-oxide or silicon nitride.

According to an embodiment of the present invention, the group III-V material layer comprises at least a layer of group III-V compound nitride. The group III-V compound nitride is selected from a group consisting of GaₓN_{y}, Al_{z}GaₓN_{y} and InₚAl_{q}GaₓN_{y}, with p,q,x,y being real numbers such that p+q+x+y=1.

According to an embodiment of the present invention, the group III-V material layer comprises multiple layers of III-V compound nitride.

According to an embodiment of the present invention, the exposed layer of the group III-V material layer after a chemical mechanical polishing process is a Ga_{X}N_{Y} layer.

According to an embodiment of the present invention, the method of fabricating a group III-V material-on-silicon substrate further comprises forming an AIN buffer layer on the silicon substrate. The AIN buffer layer is formed on the exposed silicon substrate after patterning the first layer.

According to an embodiment of the present invention, the method of fabricating a group III-V material-on-silicon substrate further comprises the step of growing a semiconductor layer on the plurality of areas until a semiconductor layer merges with a neighboring semiconductor layer thereby forming the a device layer.

According to an embodiment of the present invention, the semiconductor layer is selected from the group consisting of GaₓN_{y}, Al_{z}GaₓN_{y} and InₚAl_{q}GaₓN_{y}, with p,q,x,y being real numbers such that p+q+x+y=1.

According to an embodiment of the present invention, a group III-V material-on-silicon substrate is provided. The group III-V material-on-silicon substrate comprises a silicon substrate and a patterned first layer is formed over the silicon substrate. A group III-V material layer is formed on the exposed silicon substrate within the patterned first layer.

According to an embodiment of the present invention, the group III-V material layer formed on the exposed silicon substrate comprises at least one layer of group III-V compound nitride. The group III-V compound nitride is selected from a group consisting of GaₓN_{y}, Al_{z}GaₓN_{y} and InₚAl_{q}GaₓN_{y}, with p,q,x,y being real numbers such that p+q+x+y=1.

These and other aspects of the embodiments of the present invention will be better appreciated and understood when considered in conjunction with the following description and the accompanying drawings. It should be understood, however, that the following descriptions, while indicating preferred embodiments and numerous specific details thereof, are given by way of illustration and not of limitation. Many changes and modifications may be made within the scope of the embodiments of the present invention without departing from the spirit thereof, and the embodiments of the present invention include all such modifications.

### BRIEF DESCRIPTION OF THE DRAWINGS

The other objects, features and advantages will occur to those skilled in the art from the following description of the preferred embodiment of the present invention and the accompanying drawings in which:
FIG. 1a - FIG. 1c illustrate the steps involved in a method for fabricating a group III-V material on silicon substrate, according to an embodiment of the present invention.
FIG.2a - FIG. 2d illustrate the steps involved in a method for fabricating a group III-V material on silicon substrate including a step of forming an AIN buffer layer on a silicon substrate, according to an embodiment of the present invention.
FIG.3 illustrates side view of silicon substrate with a group III-V material and a semiconductor layer, according to an embodiment of the present invention.

Although the specific features of the embodiments herein are shown in some drawings and not in others. This is done for convenience only as each feature may be combined with any or all of the other features in accordance with the embodiments herein.

### DETAILED DESCRIPTION OF THE EMBODIMENTS

In the following detailed description, a reference is made to the accompanying drawings that form a part hereof, and in which the specific embodiments that may be practiced is shown by way of illustration. These embodiments are described in sufficient detail to enable those skilled in the art to practice the embodiments and it is to be understood that the logical, mechanical and other changes may be made without departing from the scope of the embodiments. The following detailed description is therefore not to be taken in a limiting sense.

A preferred embodiment of the present invention discloses a method of fabricating a group III-V material-on-silicon substrate by first forming a first layer over the silicon substrate. The first layer formed over the silicon substrate is patterned to expose the silicon substrate. A group III-V material layer is formed over the patterned first layer and on the exposed silicon substrate. A chemical mechanical polishing of the group III-V material layer is performed to expose the first layer to form a plurality of areas for growing a device layer on the silicon substrate. The first layer can be a layer of a dielectric material, such as silicon-oxide or silicon-nitride, but can also a layer of Alumina-oxide or W.

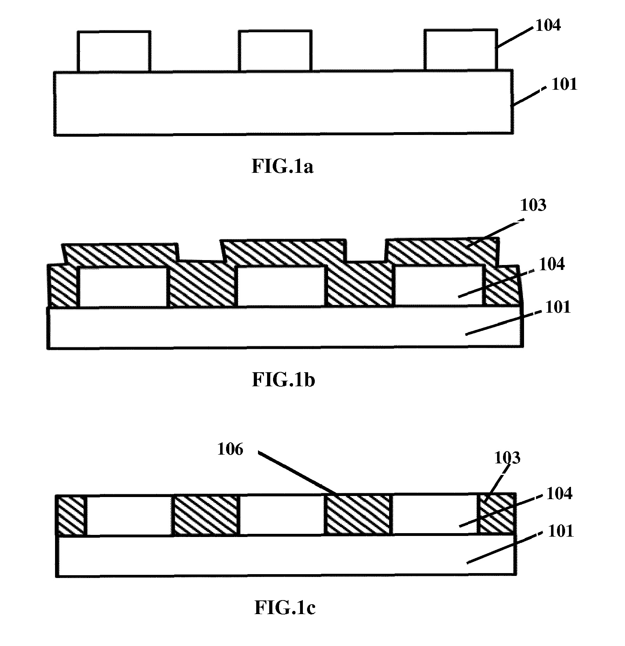

FIG. 1a - FIG. 1c illustrate the various steps in a method of fabricating a group III-V material on a silicon substrate 101. With respect to FIG. 1a, a substrate 101 which is a part of a semiconductor wafer is provided.

According to one embodiment of the present invention, a silicon substrate 101 with a pre-defined surface orientation is provided. A first layer 104 is formed on the top surface of the silicon substrate 101. The first layer 104 is uniformly laid upon the top surface of the silicon substrate 101. According to one embodiment of the present invention, the first layer 104 is a silicon-oxide layer. Optionally, the first layer is formed on a silicon nitride, e.g. SiN, layer provided over the silicon substrate 101.

According to one embodiment of the present invention, the first layer is selectively patterned thereby resulting in the formation of a plurality of areas of the first layer. The first layer 104 is patterned to expose the silicon substrate 101.

A plurality of areas comprising the dielectric material 104 is selectively formed on the surface of the silicon substrate 101, as shown in FIG.1a. Subsequently, a group III-V material layer, 103, is formed over the patterned first layer 104 and on the exposed surfaces of the silicon substrate 101, as shown in FIG.1b. The group III-V material layer 103 is grown in the trenches formed as a resultant of patterning of the first layer 104. The bottom surface of the trenches formed as a result of patterning is typically crystalline in nature, i.e. the exposed silicon substrate 101. Therefore, the growth of the group III-V material layer here is relatively faster than that on the sidewalls of the trenches and on top of the patterned first layer. The group III-V material layer grown on a surface of the first layer is typically not mono-crystalline. In accordance with the first embodiment of the present disclosure, the step of patterning the first layer 104 also includes the optional step of etching a plurality of trenches that extend onto the silicon substrate 101. The trenches extending on to the silicon substrate 101 are used for compressive stress management and relief.

According to an embodiment of the present invention, the group III-V material layer includes at least one layer of group III-V compound nitride. The group III-V compound nitride is typically selected from the group of compounds consisting of GaₓN_{y}, Al_{z}GaₓN_{y} and InₚAl_{q}GaₓN_{y}, with p, q, x, y being real numbers such that p+q+x+y=1.

With reference to FIG. 1c, the chemical mechanical polishing of the group III-V material layer 103 is performed to expose the first layer 104 to form the plurality of areas 106 which are suitable for growing a device layer on the silicon substrate 101.

Typically, a semiconductor device such as an FET or a light-emitting device can be formed on the silicon substrate 101. In case of a light-emitting device, the device layer assumes a multi-quantum structure (MQW) or a single quantum structure (SQW) or a homo-structure or a single heterostructure or a double hetero structure.

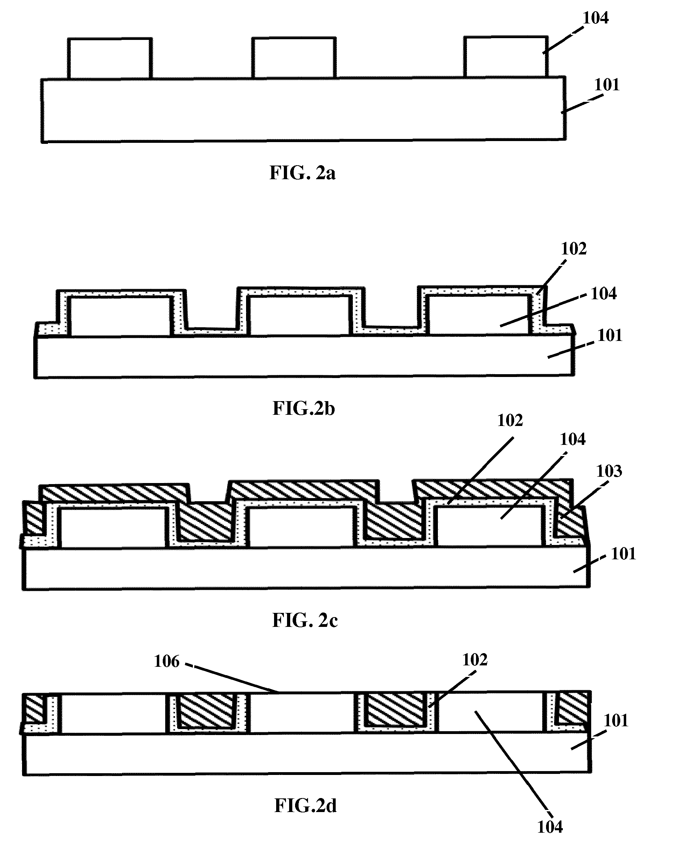

FIG. 2a - FIG. 2d illustrate the steps involved in a method for fabricating a group III-V material on silicon substrate including a step of forming a buffer layer 102 on a silicon substrate 101, according to an embodiment of the present invention.

According to an embodiment of the present invention, the buffer layer 102 need not be restricted to an AIN buffer layer but also include a multi component layer comprising layers of different compositions. Any of the techniques including but not restricted to vapor deposition, ion plating, laser abrasion, metal organic chemical vapor deposition technique (MOCVD) and Electron Cyclotron Resonance (ECR) can be employed to bring about the formation of the buffer layer on the surface of the silicon substrate 101. A multi-component layer may comprise alternate layers of AlN (Aluminum Nitride) and AlGaN (Aluminum Gallium Nitride). Alternatively, the multi-component layer may comprise alternating layers of the same component. Alternatively the multi-component layer may comprise any number of different types of group III-V nitride compound semiconductors. The buffer layer formed on the surface of first layer104 is typically amorphous in nature. The buffer layer is typically formed on the silicon substrate 101 in order to improve the crystalline nature of the group III-V buffer layer, as it acts as buffer between these two material systems: the substrate and the group III-V material. The formation of the buffer layer 102 on the top surface of the silicon substrate 101 is typically performed at lower temperatures

According to an embodiment of the present invention, the buffer layer is an AIN buffer layer. With respect to FIG. 2a, the AIN buffer layer 102 is typically formed in a non-selective way on the top surface of the silicon substrate 101 as well as on the top surface of the first layer 104. The AIN buffer layer 102 subsequently grows on the top surface of the silicon substrate 101 and also on the areas of the dielectric material 104, as shown in FIG. 2b.

With respect to FIG.2a, the first layer 104 is formed over the silicon substrate 101. As shown in FIG. 2b, a buffer layer, such as, AIN buffer layer 102 is formed on the top surface of the patterned surfaces of the first layer 104 as well as on the top surface of the exposed silicon surface 101. As shown in FIG. 2C, group III-V material layer 103 is formed over the surface of the buffer layer 102. As shown in FIG.2d the group III-V material layer is subjected to chemical mechanical polishing (CMP) process to expose the first layer 104 and the buffer layer 102, thereby forming a plurality of areas 106 suitable for growing a device layer on the silicon substrate 101. As shown in FIG. 2d, the additional AIN buffer layer 102 is selectively removed using the chemical mechanical polishing technique. As shown in FIG. 2d, the chemical mechanical polishing process forms a flat surface suitable for the growth of a semiconductor device layer. As shown in FIG. 2d, the patterned areas of the dielectric material 104 and the group III-V material layer 103, are used as a roughened surface.

According to an embodiment of the present invention, the non-crystalline (amorphous) material on top of the patterned first layer is removed selectively with respect to the crystalline material using the chemical mechanical polishing technique, thereby avoiding the creation of crystal defects in the regions limited by the non-crystalline material, which would have had a negative impact on the subsequent nitride layers.

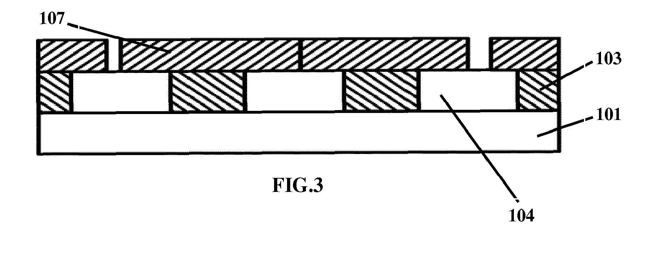

FIG. 3a illustrates the step of growing a semiconductor layer on the plurality of areas 106 (as shown in FIG.1c and FIG. 2d) until a semiconductor layer merges with a neighboring semiconductor layer thereby forming a device layer 107. According to an embodiment of the present invention, a selective Area Growth (SAG) technique is utilized to grow the semiconductor layer on the plurality of areas 106. The Selective Area Growth technique involves creating a mask layer 104 on the surface of the group III-V material layer 103. The mask layer is a preset dielectric mask pattern. Due to the masking properties associated with the mask layer, the growth of the semiconductor layer 107 occurs only in the areas 106 limited by the group III-V material layer 103. The grown semiconductor layer 107 is isolated into individual semiconductor device layers using the mask layer. A plurality of isolated, individual, self-aligned semiconductor device layers is formed by increasing the lateral dimension of the dielectric mask pattern. The semiconductor layer 107 is selectively and epitaxial grown on the group III-V material layer 103 using the preset dielectric pattern until a semiconductor layer merges with a neighboring semiconductor device layer as shown in FIG. 3a, to form the desired device layer.

According to an embodiment of the present invention, the semiconductor layer 107 is grown by the way of a two-step epitaxial lateral overgrowth (ELOG) process. In the first step, an AIN buffer layer 102 (as shown in FIG.2c) is formed with the pattern of the first layer 104 and the group III-V material layer 103. Subsequent to the formation of the AIN buffer layer 102, the semiconductor layer 107 is grown on the plurality of areas 106. The semiconductor layer 107 typically comprises graded GaN layers. The two step epitaxial lateral overgrowth process provides for properties such as thickness, stress, mutual stress compensation and the quality of both the layers. The AIN buffer layer 102 and the device layer are decoupled, thereby providing for individual optimization. For example, the AIN buffer layer 102 and the device layer can be grown to the maximum permissible thickness, typically 5µm, thereby overcoming the limitations imposed by the prior art through one step epitaxial lateral overgrowth procedure. The device layer comprises a bottom layer of undoped GaN (preferably having a thickness of 500nm) acting as a contact between the AIN buffer layer 102 and the plurality of doped layers of GaN (each having a thickness of preferably 2 µm) located atop the doped GAN layer and forming a part of the device layer.

According to an embodiment of the present invention, the growth of the semiconductor layer 107 in the plurality of areas 106 results in the creation and build-up of compressive stress. The AIN in the buffer layer 102 builds a tensile stress thereby compensating for the compressive stress exhibited by the device layer.

The device layer formed in accordance with the method of the present invention has better crystal quality due to annihilation of dislocations propagating from the neighboring pockets. The semiconductor layer isolation brought about by the method of the present invention reduces wafer bow, layer cracking and wafer breakage.

The foregoing description of the embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the spirit and scope of the appended claims.

Although the embodiments of the present invention are described with various specific embodiments, it will be obvious for a person skilled in the art to practice the invention with modifications. However, all such modifications are deemed to be within the scope of the claims.

It is also to be understood that the following claims are intended to cover all of the generic and specific features of the embodiments described herein and all the statements of the scope of the embodiments which as a matter of language might be said to fall there between.

## Claims

1. A method of fabricating a group III-V material-on-silicon substrate comprising steps of:
providing a silicon substrate (101);
forming a first layer (104) over the silicon substrate (101);
patterning the first layer (104) to expose the silicon substrate (101);
forming a group III-V material layer (103) over the patterned first layer (104) and on the exposed silicon substrate (101), and;
chemical mechanical polishing (CMP) the group III-V material layer (103) to expose the first layer (103) thereby forming a plurality of areas (106) for growing a device layer on the silicon substrate (101).

2. The method according to claim 1, wherein the material of the first layer (104) is a dielectric material.

3. The method according to claim 2, wherein the first layer (104) is a silicon-oxide layer.

4. The method according to claim 1, 2 or 3, wherein the group III-V material layer (103) comprises at least a layer of group III-V compound nitride.

5. The method according to claim 4, wherein the group III-V compound nitride is selected from a group consisting of GaₓN_{y}, Al_{z}GaₓN_{y} and InₚAl_{q}GaₓN_{y}, with p,q,x,y being real numbers such that p+q+x+y=1.

6. The method according to claim 5, wherein the group III-V material layer (103) comprises multiple layers of III-V compound nitride, and wherein an exposed layer of the group III-V material layer after CMP is a GaₓN_{y} layer.

7. The method according to any of the foregoing claims, further comprising an AlN buffer layer (102) formed on the silicon substrate (101).

8. The method according to claim 7, wherein the AlN buffer layer (102) is formed on the exposed silicon substrate (101) after patterning the first layer (104).

9. The method according to any of the foregoing claims, further comprises:
growing a semiconductor layer (107) on the plurality of areas (106) until a semiconductor layer merges with a neighbouring semiconductor layer thereby forming the device layer.

10. The method of claim 9, wherein the semiconductor layer is selected from a group consisting of GaₓN_{y}, Al_{z}GaₓN_{y} and InₚAl_{q}GaₓN_{y}, with p,q,x,y being real numbers such that p+q+x+y=1.

11. A group III-V material-on-silicon substrate comprising:
a silicon substrate (101);
a patterned first layer (104) over the silicon substrate (101); and
a group III-V material layer (103) on the exposed silicon substrate (101) within the patterned first layer (104).

12. The substrate according to claim 11, wherein the group III-V material layer (103) comprises at least a layer of group III-V compound nitride.

13. The substrate according to claim 12, wherein the group III-V compound nitride is selected from a group consisting of GaₓN_{y}, Al_{z}GaₓN_{y} and InₚAl_{q}GaₓN_{y}, with p,q,x,y being real numbers such that p+q+x+y=1.
